# EUROPEAN PATENT APPLICATION

(11) **EP 1 967 497 A2**
(43) Date of publication of application: **10.09.2008**
(21) Application number: 08250618.9
(22) Date of filing: 22.02.2008
(51) Int. Cl.: C02F 1/467, C02F 1/461, C25B 11/12

(54) **Granular diamond and diamond electrode using the same**

(30) Priority: 27.02.2007 JP 2007046981
(71) Applicant: Sumitomo Electric Hardmetal Corp., Itami-shi, Hyogo 664-0016 (JP)
(72) Inventor: Yoshida, Shigeru, Itami-shi Hyogo 664-0016 (JP); Yoshida, Katsuhito, Itami-shi Hyogo 664-0016 (JP)
(74) Representative: Cross, Rupert Edward Blount

(57) **Abstract**

This invention provides a granular diamond(1) consisting of: a columnar base(2) formed by Nb, Ti or W and having a length(L) in a longitudinal direction of not more than 30 mm and a maximum length(R) in a direction perpendicular to the longitudinal direction of not more than 15 mm; and conductive diamond(3) coating not less than 30% of a surface of the base(2), or a granular diamond including: a spherical base formed by Nb, Ti or W and having a diameter of not more than 15mm, and conductive diamond coating not less than 50% of a surface of the base, and a diamond electrode having a great surface area and a high conductivity by using such many granular diamonds.

## Description

### BACKGROUND OF THE INVENTION

### Field of the Invention

The present invention relates to a granular diamond and a diamond electrode using the same.

### Description of the Background Art

Recently, there has been an attempt to use diamond, being rendered conductive by addition of a dopant such as boron (conductive diamond), as an electrode for performing electrochemical processing of various solutions (for example, electrolysis of water for obtaining electrolyzed water used in the fields of medical and food or for cleaning electronic components, electrolysis of water for wastewater treatment and the like). Such an electrode using the conductive diamond (a diamond electrode) is required to have a great surface area and a high conductivity.

Conventionally, a diamond electrode is manufactured by coating the surface of a base with conductive diamond, by CVD (Chemical Vapor Deposition) using carbon-containing gas such as methane as a main material. In order to realize a high conductivity, it is necessary to use metal such as Nb (niobium), Ti (Titan) and the like as the base. On the other hand, there has been a problem that, when a plate-like object (a plate-like object in which the area of a main surface is not less than 10-10000 cm² and thickness is about 1-3 mm) formed with metal such as Nb, Ti and the like is used as the base in order to obtain greater surface area, crack or peeling of the conductive diamond tends to occur in the resulting diamond electrode. It is considered that the crack or peeling of the conductive diamond is caused by residual stress attributed to a difference in coefficient of thermal expansion between the diamond and the metal during CVD.

It may also be possible to manufacture a diamond electrode by employing a base of silicon or SiC of which difference in coefficient of thermal expansion between diamond is small relative to the above-described metal, and coating the base with conductive diamond by CVD. In this case, however, though the above-described crack or peeling of the conductive diamond does not easily occur, there is a disadvantage that a high conductivity is not obtained.

Thus, it has been difficult to obtain a diamond electrode that has both the two features of a great surface area and a high conductivity.

Now, for example, Japanese Patent Laying-Open No. 2004-358452 (Patent Document 1) discloses an electrolytic treatment apparatus using an electrode obtained by coating a base made of a lattice-shaped round bar with conductive diamond. Patent Document 1 discloses that, by exposing the edge faces of the base made of the lattice-shaped round bar to the outside of the electrolytic cell without coating the edge faces with the conductive diamond, the aforementioned peeling of conductive diamond by residual stress attributed to a difference in coefficient of thermal expansion during CVD can be suppressed. However, with the electrode disclosed in Patent Document 1, the length of the round bar by which peeling of diamond is prevented is actually limited. Accordingly, the size of an electrode that can be implemented is limited, and therefore it is not applicable to electrochemically process a large amount of solution at a time.

As a technique of manufacturing a diamond electrode of a large size using CVD, for example, Japanese Patent Laying-Open No. 2004-321962 (Patent Document 2) discloses electrodes in which a plurality of conductive diamond pieces are fixed on a large substrate (base) in parallel by a conductive paste. However, with the electrode disclosed in Patent Document 2, the conductive paste may be dissolved into the solution from the gap between the electrodes fixed in parallel.

For example, Japanese Patent Laying-Open No. 2005-290403 (Patent Document 3) discloses an electrolysis method. Accordingly to the method, a polycrystal of conductive diamond manufactured by CVD, or conductive diamond particles obtained by breaking the polycrystal is/are immersed into an electrolytic solution so as to be interposed between electrodes arranged to face each other. Then, a voltage is applied to the conductive diamond via the electrodes. However, since the method disclosed in Patent Document 3 uses solely the conductive diamond, it is not possible to attain a high conductivity.

### SUMMARY OF THE INVENTION

The present invention has been made to solve the above-described problems, and an object thereof is to provide a granular diamond having a great surface area and a high conductivity, and a diamond electrode using the same.

The present invention provides a granular diamond (hereinafter referred to as "the first granular diamond"), including: a columnar base formed by Nb, Ti or W and having a length in a longitudinal direction of not more than 30 mm and a maximum length in a direction perpendicular to the longitudinal direction of not more than 15 mm; and conductive diamond coating not less than 30% of a surface of the base.

Preferably, in the first granular diamond of the present invention, the columnar base has the length in the longitudinal direction of not less than 2 mm and the maximum length in the direction perpendicular to the longitudinal direction of not less than 1 mm.

The present invention also provides a granular diamond (hereinafter referred to as "the second granular diamond"), including: a spherical base formed by Nb, Ti or W and having a diameter of not more than 15 mm; and conductive diamond coating not less than 50% of a surface of the base.

Preferably, in the second granular diamond of the present invention, the diameter of the spherical base is not less than 2 mm.

The present invention also provides a diamond electrode using the above-described granular diamond of the present invention (the first granular diamond and/or second granular diamond).

According to the granular diamond of the present invention, even when conductive diamond is formed by CVD so as to coat the surface of the base formed by Nb, Ti or W, crack or peeling of the conductive diamond, which is invited by residual stress attributed to a difference in coefficient of thermal expansion between the diamond and the base during CVD, does not easily occur. Thus, a granular diamond having a great surface area and a high conductivity can be implemented. By using such a granular diamond of the present invention, a diamond electrode having a life drastically longer than that of a conventional electrode can be implemented.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 schematically shows one preferable example of a first granular diamond, which is one type of the granular diamond of the present invention, wherein Fig. 1(a) is a perspective view and Fig. 1(b) is a cross-sectional view along a cross-section line IB-IB in Fig. 1(a).
Fig. 2 schematically shows one preferable example of a second granular diamond, which is one type of the granular diamond of the present invention, wherein Fig. 2(a) is a perspective view and Fig. 2(b) is a cross-sectional view along a cross-section line IIB-IIB in Fig. 2(a).
Fig. 3 schematically shows a diamond electrode 11 using first granular diamonds 1 of the example shown in Fig. 1.
Fig. 4 schematically shows a diamond electrode 16 using second granular diamonds 6 of the example shown in Fig. 2.
Fig. 5 schematically shows an electrolysis apparatus 21 using diamond electrode 11 shown in Fig. 3.

### DESCRIPTION OF THE PREFERRED EMBODIMENTS

In a granular diamond of the present invention, a base formed by Nb (niobium), Ti (titanium) or W (Tungsten) is used. Accordingly, the granular diamond having a high conductivity (specifically, about 5.0 × 10⁴ - 2 × 10⁵ / mΩ) is realized, as compared to a case where a base formed by silicon, SiC or the like is used. The present invention is also advantageous in that, since Nb, Ti or W being valve metal is used as a material for forming the base, even when the surface of the base is not entirely coated by conductive diamond and the surface of the base is partially exposed, the exposed base surface does not contribute to electrolysis. The granular diamond of the present invention is characterized in use of a base of particular shape and size as the above-described base, and can generally be classified into two types depending on the shape and size of the base.

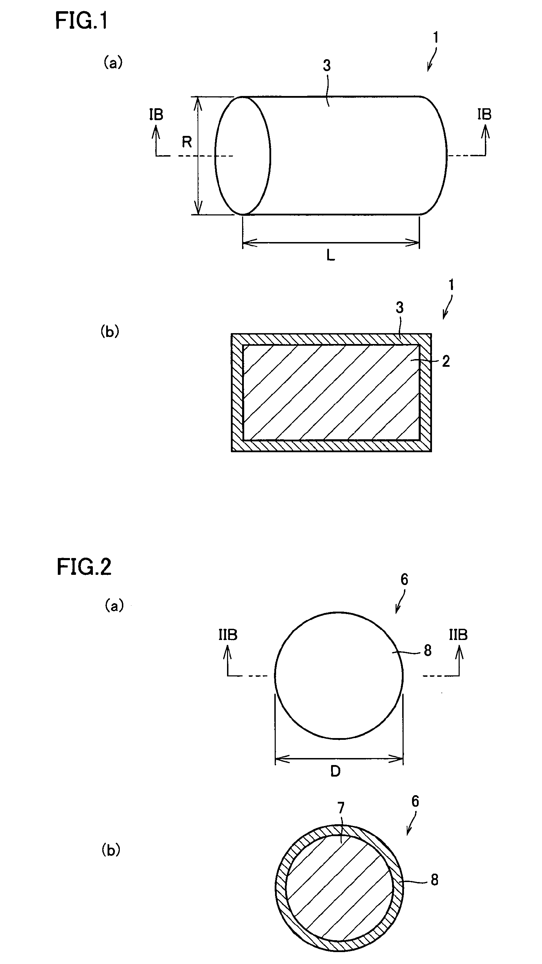

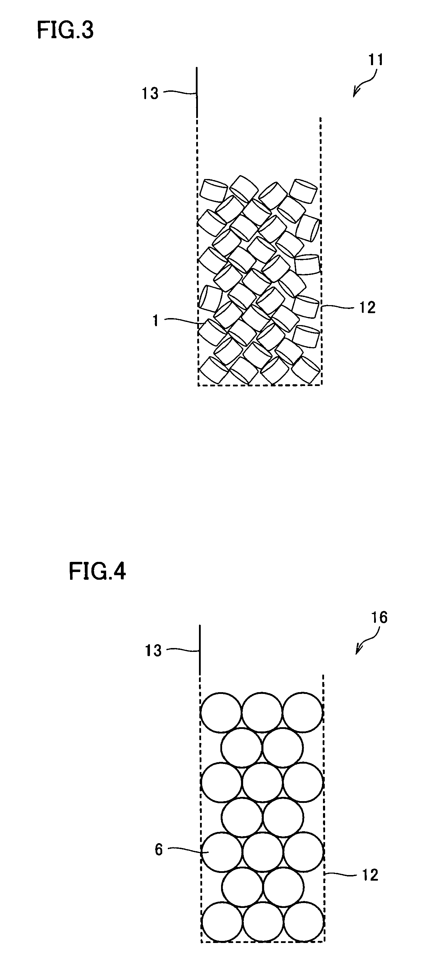

Fig. 1 schematically shows one preferable example of a first granular diamond, which is one type of the granular diamond of the present invention. Fig. 1(a) is a perspective view and Fig. 1(b) is a cross-sectional view along a cross-section line IB-IB in Fig. 1(a). First granular diamond 1 of the present invention basically includes a columnar base 2 having a particular size, and conductive diamond 3 coating the surface of base 2. As used herein, "columnar" refers to a shape elongated in one direction (the direction being referred to as "the longitudinal direction"), every cross section of which perpendicular to the longitudinal direction has substantially the same cross-sectional area. The shape may be solid or hollow. Use of the columnar base is advantageous in that, as compared to use of a base of other shape, granular diamonds as packed in a column shown in Fig. 3 form great spaces that facilitate flow of electrolytic solution. Such a columnar shape may specifically include a solid or hollow cylindrical or prismatic (triangular prism, quadrangular prism, polygonal prism and the like) shape. Among others, a solid cylindrical shape as shown in Fig. 1 is preferable, since there are fewer edge portions where conductive diamond tends to peel off or brake.

First granular diamond 1 of the present invention is characterized in that above-described columnar base 2 has a length in the longitudinal direction (length L in the example of Fig. 1) of not more than 30 mm and a maximum length (diameter R in the example of Fig. 1) in the direction perpendicular to the longitudinal direction of not more than 15 mm. As the first granular diamond of the present invention has base 2 of such a size, even when conductive diamond is formed so as to coat the surface of the base by CVD, the conductive diamond is less likely to crack or peel off by residual stress attributed to a difference in coefficient of thermal expansion between the diamond and the base during CVD, in spite of use of the base formed by Nb, Ti or W. This feature of conductive diamond being less likely to crack or peel off can be evaluated by, for example, observing the appearance of the conductive diamond coating the base using a stereoscopic microscope to see if it cracks or peels off. The first granular diamond of the present invention also has an advantage of an increased surface area realized by use of a base having a length in the longitudinal direction of not more than 30 mm and a maximum length in the direction perpendicular to the longitudinal direction of not more than 15 mm, as compared to a case where a plate-like base is used. Thus, by the present invention, a granular diamond having a great surface area and a high conductivity is realized.

Preferably, the columnar base in the first granular diamond of the present invention has a length in the longitudinal direction of not less than 2 mm and a maximum length in the direction perpendicular to the longitudinal direction of not less than 1 mm, for the following reasons. If the length in the longitudinal direction is less than 2 mm, the granular diamonds are packed in the column shown in Fig. 3 densely. Thus, bubbles generated by electrolysis are not released and the following electrolysis tends to be hindered (the electrolysis efficiency may be reduced). Also, if the maximum length in the direction perpendicular to the longitudinal direction is less than 1 mm, damages such as braking or bending may be incurred.

One major feature of the first granular diamond of the present invention is that not less than 30% of the surface of the above-described columnar base is coated with conductive diamond. This is because a practical electrolysis performance is hardly obtained if the conductive diamond only coats less than 30% of the surface of the base. Considering the realization of a granular diamond having high electrolysis performance, preferably a greater proportion of the surface of the base is coated with the conductive diamond. Ideally, 100% of the surface of the base is coated with the conductive diamond.

Such conductive diamond can be obtained by adding a dopant (impurity) to diamond to render the diamond conductive. The dopant added to the diamond may include, for example, phosphorus, nitride, boron or the like, while being not limited thereto. Among others, conductive diamond having boron added as a dopant is preferable, since a high conductivity is realized by addition of a small amount of boron. Boron oxide, diphosphorous pentaoxide, trimethyl borate, nitride gas and the like may suitably be used as a material of such a dopant, since they are less toxic.

In the conductive diamond used in the present invention, while an addition amount of the aforementioned dopant is not specifically limited, it is preferably in a range of 1 - 10000 ppm and more preferably in a range of 100 - 10000 ppm, for the following reasons. If the addition amount is less than 1 ppm, the conductivity is too low and may not be used in electrolysis. Also, if the addition amount of the dopant is more than 10000 ppm, the crystallinity of the conductive diamond is reduced and the electrochemical feature specific to the conductive diamond may be lost. It is to be noted that the addition amount of the dopant in the conductive diamond refers to a value measured using an SIMS (Secondary Ion Mass Spectrometry), for example.

In the granular diamond of the present invention, the conductive diamond is formed in a manner of a film over the surface of the base to coat the surface. While the thickness of the conductive diamond is not specifically limited, preferably it is in a range of 3 - 50 µm, and more preferably in a range of 5 - 20 µm, for the following reasons. If the thickness of the conductive diamond is less than 3 µm, pinholes may occur in the conductive diamond and the conductive diamond may peel off from the base during electrolysis. Also, if the thickness of the conductive diamond is more than 50 µm, the conductive diamond may be damaged by internal stress in the conductive diamond and the conductive diamond may peel off from the base. It is to be noted that the thickness of the conductive diamond refers to a value measured by observing the cross section of the granular diamond using an SEM (Scanning Electron microscope), for example.

Fig. 2 schematically shows one preferable example of a second granular diamond, which is one type of the granular diamond of the present invention. Fig. 2(a) is a perspective view and Fig. 2(b) is a cross-sectional view along a cross-section line IIB-IIB in Fig. 2(a). Second granular diamond 6 of the present invention basically includes a spherical base 7 having a particular size, and conductive diamond 8 coating the surface of base 7. Use of a spherical base is advantageous in that, as compared to use of a base of other shape, granular diamonds packed in a column shown in Fig. 3 are allowed to be arranged uniformly as a whole. Therefore, when electrolysis is performed using a diamond electrode obtained by packing the spherical granular diamonds in a column, electrolysis processing is performed uniformly by the entire diamond electrode. Spherical base 7 for use in second granular diamond 6 of the present invention may be solid or hollow (Fig. 2 shows a hollow spherical example).

When base 7 is spherical as in the example of Fig. 2, a base having diameter D of not more than 15 mm is used, for the following reasons. If a spherical base having diameter D of more than 15 mm is used, when the conductive diamond is formed on the surface, the conductive diamond may crack or peel off. Thus, a granular diamond having a great surface area and a high conductivity cannot be realized. Use of spherical base 7 having diameter D of not more than 15 mm is also advantageous in that uniform conductive diamond is formed.

Preferably, in second granular diamond 6 of the present invention, diameter D of above-described spherical base 7 is not less than 2 mm, for the following reason. If the diameter of the spherical base is less than 2 mm, the granular diamonds are packed in the column shown in Fig. 3 densely. Thus, bubbles generated by electrolysis are not released and the following electrolysis tends be hindered (the electrolysis efficiency may be reduced).

One major feature of the second granular diamond of the present invention is that not less than 50% of the surface of the above-described spherical base is coated with conductive diamond. This is because a practical electrolysis performance is hardly obtained if the conductive diamond only coats less than 50% of the surface of the base. Similarly to the above-described first granular diamond, also as to the second granular diamond, considering the realization of a granular diamond having high electrolysis performance, preferably a greater proportion of the surface of the base is coated with the conductive diamond. Ideally, 100% of the surface of the base is coated with the conductive diamond.

The type, addition amount, thickness and the like of the dopant of the used conductive diamond in the second granular diamond of the present invention are the same as described above as to the first granular diamond.

While a manufacturing method of the above-described granular diamond of the present invention is not specifically limited, it may preferably be manufactured by preparing a base formed by Nb, Ti or W in the above-described shape and size (for example, by using an appropriate commercially available product), and by forming the conductive diamond in a manner of a film by CVD on the surface of the base, for example. It goes without saying that coating of the conductive diamond by CVD can be performed for a plurality of times while changing the direction of the base, in accordance with the shape of the base (for example, in case of a spherical base, coating of the conductive diamond is performed by CVD on one hemisphere, and thereafter, turning over the base, coating of the conductive diamond is performed by CVD on the other hemisphere).

Formation of the conductive diamond by CVD can be performed by using an appropriate, conventionally known CVD apparatus. For example, hot-filament CVD, microwave plasma CVD or the like can suitably be employed. While the conditions of CVD are not specifically limited, hot-filament CVD can suitably be performed under conditions of, for example, for each single CVD: filament temperature of about 1800 - 2400°C; base temperature of about 750 - 950°C; pressure of about 2000 - 100000 Pa (hydrogen gas atmosphere); gas concentration of organic compound (such as methane, alcohol) relative to hydrogen gas of about 0.1 - 10 volume %; dopant gas concentration relative to the organic compound of about 0.001 - 1 volume %; and gas feeding rate of about 0.01 - 10 liter/min. Microwave plasma CVD can suitably be performed under conditions of, for example, for each single CVD: plasma output of about 1 - 5 kW; pressure inside chamber of about 4000 - 15000 Pa; introduction flow rate of a mixture gas of hydrogen, carbon source and dopant of about 10 - 100 ml/min (with the same gas composition ratio as in the hot-filament CVD).

When coating the surface of the above-described columnar base (for example, the example shown in Fig. 1) with the conductive diamond, it goes without saying that the first granular diamond of the present invention may be manufactured by forming conductive diamond by CVD on a columnar object having a length corresponding to the total length of a plurality of the bases in the longitudinal direction, and cutting it into a desired size. The advantage of manufacturing the first granular diamond in such a manner is a highly improved manufacturing efficiency. In this case, as means for cutting the columnar object having the conductive diamond formed thereon into a plurality of pieces, dicing, wire electrical discharge machining, laser, waterjet and the like may suitably employed, for example.

Fig. 3 schematically shows a diamond electrode 11 using first granular diamonds 1 of the present invention of the example shown in Fig. 1. Fig. 4 schematically shows a diamond electrode 16 using second granular diamonds 6 of the present invention of the example shown in Fig. 2. As described above, both the first and second granular diamonds have the great surface area and high conductivity, which can suitably be used for a diamond electrode for performing electrochemical processing of various solutions, for example, electrolysis of water for obtaining electrolyzed water used in the fields of medical and food or for cleaning electronic components, electrolysis of water for wastewater treatment and the like. Accordingly, the present invention also provides a diamond electrode using the granular diamonds of the present invention.

The diamond electrode of the present invention is advantageous in that it is excellent in durability by use of the granular diamonds of the present invention, as compared to a conventional diamond electrode. The excellent durability of the diamond electrode of the present invention can be checked by evaluating the life of the electrode by, for example, a test (accelerated test) of performing electrolysis while passing current that is some times to 10 times greater (5 - 30 A/cm²) than current usually used (0.5 - 3 A/cm²), and measuring the time until the conductive diamond peels off.

Each diamond electrode 11, 16 of the present invention is implemented by, for example as respectively shown in Figs. 3 and 4, packing a multiple of granular diamonds 1, 6 in mesh-like metal column 12 and electrically connecting a feeding line 13 to column 12. Multiple of granular diamonds 1, 6 packed in column 12 are electrically continuous to each other by contacting each other, and can be regarded as one porous electrode in the packed state. That is, each diamond electrode 11, 16 having a great surface area and a high conductivity is realized.

In each diamond electrode 11, 16, as column 12, one formed by metal such as aluminum, tantalum, niobium, titanium, hafnium, zirconium, zinc or the like can be used. Among others, column 12 formed by titanium is preferable for its extremely high corrosion resistance. As column 12, preferably a mesh-like column of which wire diameter is in a range of 0.1 - 3 mm and opening size is in a range of 0.3 - 14 mm is used. It is to be noted that Figs. 3 and 4 show merely examples of the diamond electrode of the present invention, and the diamond electrode of the present invention is not limited to the configurations shown in Figs. 3 and 4.

The diamond electrode of the present invention only requires that at least one of above-described first granular diamond 1 and second granular diamond 6 of the present invention is used. First granular diamond 1 and second granular diamond 6 may be used in combination. Also, first granular diamonds 1 and/or second granular diamonds 6 of different sizes may be used in combination. In consideration of uniform electrolysis efficiency over the diamond electrode in which granular diamonds are packed in the above-described column, the diamond electrode of the present invention is preferably realized using granular diamonds 1, 6 of the same shape and size, as shown in Figs. 3 and 4.

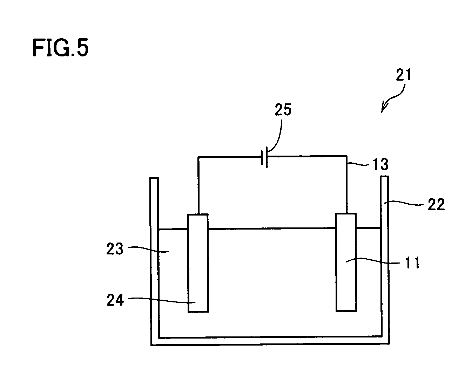

Fig. 5 schematically shows an electrolysis apparatus 21 using diamond electrode 11 of the present invention of the example shown in Fig. 3. Electrolysis apparatus 21 of the example shown in Fig. 5 is configured as follows, for example. An electrolytic solution 23 is stored in an electrolytic cell 22. In electrolytic solution 23, above-described diamond electrode 11 (used as an anode electrode) of the present invention and a cathode electrode 24 are immersed, and diamond electrode 11 and cathode electrode 24 are electrically connected to each other. In the example shown in Fig. 4, a power supply 25 is electrically connected between cathode electrode 24 and diamond electrode 11. With such electrolysis apparatus 21, electrochemical processing of various solutions using the above-described diamond electrode of the present invention can suitably be performed. It is to be noted that Fig. 5 shows merely an example, and it goes without saying that the electrolysis apparatus using the diamond electrode of the present invention is not limited to the configuration shown in Fig. 5. While Fig. 5 shows the case where diamond electrode 11 in the example shown in Fig. 3 is used, it goes without saying that diamond electrode 16 in the example shown in Fig. 4 may alternatively be used.

In the following, the present invention is described in further detail showing experiments. The present invention is not limited to them.

### (Experimental Example 1)

Samples (1-12) of 12 types of spherical or cylindrical base samples in the shape and size shown in Table 1 were prepared. On the surface of each sample, a film-like conductive diamond having boron concentration of 1000 ppm was formed by hot filament CVD, whereby the surface was coated and a granular diamond was produced. Coating of the conductive diamond by hot-filament CVD was performed twice. After the first coating, examination was performed by observing the appearance of the conductive diamond by a stereoscopic microscope, and when there is no irregularity such as crack or peeling of the conductive diamond, the base was turned over and the second coating was performed. Also after the second coating, examination for irregularity was performed by observing the appearance of the conductive diamond by the stereoscopic microscope. Each of the samples was formed so that the conductive diamond had average thickness of 10 µm.

The shape, size, and result of the appearance examination of each sample are shown in Table 1.

**[Table 1]**

| Sample No. | Shape | Size (mm) | Result of appearance examination |
|---|---|---|---|
| 1 | Spherical | Diameter D = 1.5 | Regular |
| 2 | | Diameter D = 2 | Regular |
| 3 | | Diameter D = 8 | Regular |
| 4 | | Diameter D = 15 | Regular |
| 5 | | Diameter D = 20 | Conductive diamond after second coating cracked and peeled |
| 6 | Cylindrical | Diameter R = 0.70, Length L = 2 | Regular |
| 7 | | Diameter R = 1, Length L = 1.5 | Regular |
| 8 | | Diameter R = 1, Length L = 2 | Regular |
| 9 | | Diameter R = 8, Length L = 16 | Regular |
| 10 | | Diameter R = I5, Length L = 30 | Regular |
| 11 | | Diameter R = 15, Length L = 40 | Conductive diamond after first coating cracked and peeled |
| 12 | | Diameter R = 20, Length L = 30 | Conductive diamond after second coating cracked and peeled |

As shown in Table 1, crack and peeling of the conductive diamond were seen in sample 5 (where a spherical base having diameter D of 20 mm was used), sample 11 (where a cylindrical base having diameter R of 15 mm and length L of 40 mm was used), and sample 12 (where a cylindrical base having diameter R of 20 mm and length L of 30 mm was used). Irregularity of the conductive diamond was not seen in the other samples 1-4, and 6-10. It was considered that crack and peeling of the conductive diamond in samples 5, 11 and 12 were caused since the residual stress by a difference in coefficient of thermal expansion between the base and the conductive diamond was great because of the samples' greater sizes as compared to the other samples. From the result of Experimental Example 1, it was considered that, diameter D must be not more than 15 mm when the base is spherical, and that length L in the longitudinal direction must be not more than 30 mm and diameter R in the direction perpendicular to the longitudinal direction must be not more than 15 mm when the base is cylindrical.

### (Experimental Example 2)

The granular diamonds using samples 1-4 and 6-10 where the conductive diamond did not crack or peel off in Experimental Example 1 (wherein the granular diamonds using samples 1-4 correspond to the second granular diamond of the present invention and the granular diamonds using samples 6-10 correspond to first granular diamond of the present invention) were packed in columns each having a feeding line electrically connected, to produce diamond electrodes as shown in Figs. 3 and 4. The employed column was a mesh-like Ti-made column (16 mm × 32 mm × 110 mm; wire diameter 0.3 mm; and opening size 1.29 mm). In each diamond electrode, the granular diamonds were packed in the number that provided the same total surface area (about 7050 mm²) irrespective of the size of the granular diamonds.

Using each of the produced diamond electrodes as the anode, the electrolysis apparatus as shown in Fig. 5 was produced and electrolysis tests were performed. A plate-like platinum electrode of 50 mm × 50 mm × 2 mm was used as the cathode, and cutting fluid of 1L of which COD (Chemical Oxygen Demand) was 830 mg/l was used as the electrolytic solution. The electrolysis was performed for four hours at a constant voltage of 5V, and COD concentration after the electrolysis was measured for each diamond electrode (the COD concentration was measured by COD (Cr) method).

For each sample, surface area (mm²), packed number, total surface area (mm²) and COD concentration after the electrolysis are shown in Table 2.

**[Table 2]**

| Sample No. | Shape | Size (mm) | surface area (mm²) | packed number | total surface area (mm²) | COD concentration after electrolysis processing (mg/l) |
|---|---|---|---|---|---|---|
| 1 | Spherical | Diameter D = 1.5 | 7.1 | 1000 | 7065 | 396 |
| 2 | | Diameter D = 2 | 12.6 | 563 | 7071 | 92 |
| 3 | | Diameter D = 8 | 201.0 | 35 | 7034 | 67 |
| 4 | | Diameter D = 15 | 706.5 | 10 | 7065 | 58 |
| 6 | Cylindrical | Diameter R = 0.70, Length L = 2 | 5.2 | 1368 | 7066 | 223 |
| 7 | | Diameter R = 1, Length L = 1.5 | 6.3 | 1125 | 7065 | 270 |
| 8 | | Diameter R = 1, Length L = 2 | 7.9 | 900 | 7065 | 63 |
| 9 | | Diameter R = 8, Length L = 16 | 502.4 | 14 | 7034 | 24 |
| 10 | | Diameter R = 15, Length L = 30 | 1766.3 | 4 | 7065 | 31 |

Table 2 shows the result that when the granular diamonds using samples 1, 6 and 7 are used, the reduction amount of COD concentration is relatively small. The reason thereof was considered as follows. These granular diamonds were smaller in size than the others and therefore produced smaller gaps between them when packed in the column. In the gaps, the bubbles generated by the electrolysis were trapped and the following electrolysis was hindered. From the result of Experimental Example 2, it was considered that, diameter D is preferably not less than 2 mm when the base is spherical, and that length L in the longitudinal direction is preferably not less than 2 mm and diameter R in the direction perpendicular to the longitudinal direction is preferably not less than 1 mm when the base is cylindrical.

### (Experimental Example 3)

The following two types of electrodes were produced, and comparison test was performed.

### Electrode 1

A diamond electrode to which the granular diamond using the base of Sample 3 (Nb-made spherical base having diameter of 8 mm) is applied (see Experimental Example 2).

### Electrode 2

An electrode produced by packing, in a mesh-like Ti-made column as used in Experimental Example 2 (16 mm × 32 mm × 110 mm; wire diameter 0.3 mm; and opening size 1.29 mm), 35 pieces of granular diamonds produced by coating conductive diamond in average thickness of 10 µm by performing filament CVD twice as described in Experimental Example 1 on the surface of a spherical conductive Si-made base having diameter of 8 mm (resistivity: 4.0 × 10⁻³Ω·cm).

Employing each electrode 1 and 2 as the anode similarly to Experimental Example 2, an electrolysis apparatus as shown in Fig. 5 was produced (it is to be noted that, in the present Experimental Example, an electric power meter (not shown) was electrically connected between the power supply and the anode), and an electrolysis experiment was performed. Similarly to Experimental Example 2, cutting fluid of 1L of which COD was 830 mg/l was used as the electrolytic solution. Electrolysis was performed until power was used by 90Wh at a constant voltage of 5V. The COD concentration after the electrolysis was measured (The COD concentration was measured similarly to Experimental Example 2).

The result is shown in Table 3.

**[Table 3]**

| Anode | Base material | COD concentration after electrolysis processing (mg/l) |
|---|---|---|
| Electrode 1 | Nb | 52 |
| Electrode 2 | Si | 283 |

From Table 3, it can be seen that power can be used in electrolysis processing more efficiently when the base made of metal is used. It was considered that use of the metal-made base consumes smaller power in the base as compared to a case where a base made of conductive silicon is used.

Although the present invention has been described and illustrated in detail, it is clearly understood that the same is by way of illustration and example only and is not to be taken by way of limitation, the scope of the present invention being interpreted by the terms of the appended claims.

## Claims

1. A granular diamond (1), comprising:
a columnar base (2) formed by Nb, Ti or W and having a length (L) in a longitudinal direction of not more than 30 mm and a maximum length (R) in a direction perpendicular to the longitudinal direction of not more than 15 mm; and
conductive diamond (3) coating not less than 30% of a surface of said base (2).

2. The granular diamond (1) according to claim 1, wherein
said columnar base (2) has the length (L) in the longitudinal direction of not less than 2 mm and the maximum length (R) in the direction perpendicular to the longitudinal direction of not less than 1 mm.

3. A diamond electrode (11) using the granular diamond (1) according to claim 1.

4. A granular diamond (6), comprising:
a spherical base (7) formed by Nb, Ti or W and having a diameter (D) of not more than 15 mm; and
conductive diamond (8) coating not less than 50% of a surface of said base (7).

5. The granular diamond (6) according to claim 4, wherein
the diameter (D) of said spherical base (7) is not less than 2 mm.

6. A diamond electrode (16) using the granular diamond (6) according to claim 4.
